# EUROPEAN PATENT APPLICATION

(11) **EP 4 700 399 A1**
(43) Date of publication of application: **25.02.2026**
(21) Application number: 24905151.7
(22) Date of filing: 28.11.2024
(51) Int. Cl.: G01R 31/00

(54) **TEST METHOD FOR ENERGY STORAGE AND CHARGING SYSTEM, AND TEST SYSTEM**

(30) Priority: 11.07.2024 CN 202410925624
(71) Applicant: Contemporary Amperex Technology Co., Limited, Ningde, Fujian 352100 (CN); Contemporary Amperex Future Energy Technology (Shenzhen) Limited, Shenzhen, Guangdong 518100 (CN)
(72) Inventor: WU, Kai, Ningde, Fujian 352100 (CN); CHEN, Zhuo, Ningde, Fujian 352100 (CN); ZHENG, Zhimin, Ningde, Fujian 352100 (CN); CHENG, Yong, Ningde, Fujian 352100 (CN); WANG, Pengmin, Ningde, Fujian 352100 (CN)
(74) Representative: Gong, Jinping
(86) International application number: PCT/CN2024/135409
(87) International publication number: WO 2026/011666

(57) **Abstract**

The present disclosure discloses a testing method and a testing system for a storage and charging system, wherein a tester acquires first charging data about that an energy management system instructs an AC-DC converter to charge an energy storage apparatus in a case that the remaining power of the energy storage apparatus is less than or equal to a first threshold, and determines whether an energy storage function of the storage and charging system is normal; acquires second charging data about that the energy management system controls the AC-DC converter and/or the energy storage apparatus to charge a device to be charged in a case that the device to be charged is connected to the charging conversion apparatus, and determines whether a charging function of the storage and charging system is normal. The energy storage function and the charging function are tested in a case that a communication function between a battery management unit and the energy management system passes testing. The testing of the communication function is completed based on message data received by the energy management system and message data transmitted by the battery management unit, thus achieving the effective testing of the function of the storage and charging system and improving the use reliability of the storage and charging system.

## Description

### CROSS-REFERENCE TO RELATED APPLICATIONS

The present disclosure is proposed based on the Chinese patent application No. 202410925624.8 filed on July 11, 2024 and entitled "TESTING METHOD AND TESTING SYSTEM FOR STORAGE AND CHARGING SYSTEM", and claims priority of the Chinese patent application, the entire content of which is incorporated herein by reference.

### TECHNICAL FIELD

The present disclosure relates to the technical field of batteries, and in particular relates to a testing method and a testing system for a storage and charging system.

### BACKGROUND

At present, with the gradual application of integrated storage and charging systems, how to fully test the integrated storage and charging systems before they are put into market use to ensure that they can operate normally after being put into use is an urgent problem to be solved.

### SUMMARY

Embodiments of the present disclosure provide a testing method and a testing system for a storage and charging system, which can effectively test the function of the storage and charging system and improve the use reliability of the storage and charging system.

Technical solutions of the embodiments of the present application are implemented as follows:
According to a first aspect, an embodiment of the present disclosure provides a testing method for a storage and charging system, applied to a tester, the storage and charging system including an energy management system, an energy storage apparatus, and a charging conversion apparatus; the energy storage apparatus including a battery management unit; the method including:
acquiring first charging data about that the energy management system instructs an AC-DC converter to charge the energy storage apparatus in a case that the remaining power of the energy storage apparatus is less than or equal to a first threshold, and determining whether an energy storage function of the storage and charging system is normal based on the first charging data;
acquiring second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data;
where the charging conversion apparatus is respectively connected with the AC-DC converter and the energy storage apparatus; the energy storage function and the charging function are tested in a case that a communication function between the battery management unit and the energy management system passes testing; the testing of the communication function is completed based on message data received by the energy management system and message data transmitted by the battery management unit.

In this embodiment, when the energy storage function of the storage and charging system is normal, the energy management system may instruct the AC-DC converter to charge the energy storage apparatus in a case that the remaining power of the energy storage apparatus is less than or equal to the first threshold. Therefore, when the tester tests the energy storage function, it may acquire first charging data about that the energy management system instructs the AC-DC converter to charge the energy storage apparatus in a case that the remaining power of the energy storage apparatus is less than or equal to the first threshold, to determine whether the energy storage function of the storage and charging system is normal based on the first charging data, that is, determine whether the storage and charging system can automatically charge the energy storage apparatus in a case that the remaining power of the energy storage apparatus is less than or equal to the first threshold. For the charging function of the storage and charging system, under normal circumstances, three charging methods may be supported, including charging the device to be charged by using the AC-DC converter only, charging the device to be charged by using the energy storage apparatus only, and charging the device to be charged by using the AC-DC converter and the energy storage apparatus at the same time. Therefore, when the tester tests the charging function of the storage and charging system, it may acquire second charging data about that the energy management system controls the AC-DC converter and/or the energy storage apparatus to charge the device to be charged in a case that the device to be charged is connected, to determine whether the storage and charging system can normally execute the three charging methods based on the second charging data, thus achieving the effective testing of the automatic energy storage function and charging function of the storage and charging system. In addition, before the energy storage function and the charging function are tested, the communication function between the battery management unit and the energy management system may also be tested based on message data received by the energy management system and message data transmitted by the battery management unit, to ensure that the communication function between the battery management unit and the energy management system is normal. Based on the above testing, the use reliability of the storage and charging system can be effectively improved.

In some embodiments of the present disclosure, the second charging data includes third charging information, fourth charging information, and fifth charging information; the method further includes:
transmitting first charging instruction information to the energy management system, so that the energy management system controls the AC-DC converter to charge the device to be charged in response to the first charging instruction information, and acquires the third charging information, where the first charging instruction information is configured to instruct to charge the device to be charged through the AC-DC converter;
transmitting second charging instruction information to the energy management system, so that the energy management system controls the energy storage apparatus through the battery management unit to charge the device to be charged in response to the second charging instruction information, and acquires the fourth charging information; and
transmitting third charging instruction information to the energy management system, so that the energy management system controls the AC-DC converter and the battery management unit in response to the first charging instruction information to charge the device to be charged through the AC-DC converter and the energy storage apparatus, and acquires the fifth charging information.

In this embodiment, the tester may transmit first charging instruction information to the energy management system to instruct to shield the energy storage apparatus and use the AC-DC converter only to charge the device to be charged, and obtain the relevant information of the charging process, i.e., third charging information, thus achieving the effective testing of the charging function of charging by using the AC-DC converter only. The tester may transmit second charging instruction information to the energy management system to instruct to shield the AC-DC converter and use the energy storage apparatus only to charge the device to be charged, and obtain the relevant information of the charging process, i.e., fourth charging information, thus achieving the effective testing of the charging function of charging by using the energy storage apparatus only. The tester may also transmit third charging instruction information to the energy management system to instruct to charge the device to be charged by using the AC-DC converter and the energy storage apparatus at the same time, and obtain the relevant information of the charging process, i.e., fifth charging information, thus achieving the effective testing of the charging function of charging the device to be charged by using the AC-DC converter and the energy storage apparatus at the same time.

In some embodiments of the present disclosure, the energy storage apparatus includes a battery management unit; the method further includes:
acquiring first message data of the energy management system and second message data of the battery management unit before the energy storage function and the charging function are tested, where the second message data represents message data generated by the battery management unit and transmitted to the energy management system, and the first message data represents message data received by the energy management system from the battery management unit;
comparing the first message data and the second message data to obtain a comparison result; and
determining that the communication function between the battery management unit and the energy management system passes testing in a case that the comparison result is that the first message data is the same as the second message data.

In this embodiment, before the storage and charging function of the entire storage and charging system is tested, communication testing may be performed firstly. When the communication function between the battery management unit in the energy storage apparatus and the energy management system is tested, first message data received by the energy management system from the battery management unit and second message data generated by the battery management unit and transmitted to the energy management system may be acquired; then the first message data and the second message data are compared; it is determined that the communication between the battery management unit and the energy management system is correct, that is, the communication function passes testing in a case that the first message data is the same as the second message data, thus improving the communication stability and reliability of the storage and charging system in use.

In some embodiments of the present disclosure, after determining that the communication function between the battery management unit and the energy management system passes testing in a case that the comparison result is that the first message data is the same as the second message data, the method further includes:
acquiring a protection instruction generated by the energy management system in response to a fault message transmitted by the battery management unit;
acquiring the fault message of the battery management unit and determining a fault level of the fault message; and
determining that a protection function of the energy storage apparatus passes testing in a case that the protection instruction is a protection instruction corresponding to the fault level.

In this embodiment, before the storage and charging function of the entire storage and charging system is tested, a protection function of the energy storage apparatus may also be tested. A protection instruction generated by the energy management system in response to a fault message may be acquired in a case that the battery management unit transmits the fault message to the energy management system; a fault level of the fault message transmitted by the battery management unit is determined; it is determined that the protection function of the energy storage apparatus passes testing in a case that the protection instruction generated by the energy management system is an instruction for processing a fault at the fault level, thus improving the processing capacity of the storage and charging system when the energy storage apparatus is faulted, and improving the safety of the storage and charging system.

In some embodiments of the present disclosure, after determining that the communication function between the battery management unit and the energy management system passes testing in a case that the comparison result is that the first message data is the same as the second message data, the method further includes:
acquiring first voltage data of the energy storage apparatus at different levels of remaining power and second voltage data of a battery in the energy storage apparatus; and
determining that the voltage of the energy storage apparatus passes testing in a case that the first voltage data conforms to a first voltage range and the second voltage data conforms to a second voltage range.

In this embodiment, after communication function testing passes, a voltage range of the energy storage apparatus may also be tested. The tester may acquire first voltage data of the energy storage apparatus at different levels of remaining power and second voltage data of a battery in the energy storage apparatus, and determine that the voltage of the energy storage apparatus passes testing in a case that the first voltage data conforms to a corresponding first voltage range and the second voltage data conforms to a corresponding second voltage range, thus improving the stability of the energy storage apparatus in use.

In some embodiments of the present disclosure, the charging conversion apparatus includes a charging control unit; the method further includes:
acquiring first charging request information of the device to be charged in a case that the device to be charged is connected to the charging conversion apparatus, and second charging request information transmitted by the device to be charged and received by the charging control unit; and
determining that the charging control unit passes charging request response testing in a case that the first charging request information is the same as the second charging request information.

In this embodiment, whether the charging control unit in the charging conversion apparatus can correctly respond to the charging request of the device to be charged may also be tested. The tester may acquire first charging request information of the device to be charged and second charging request information received by the charging control unit from the device to be charged in a case that the device is connected to the charging conversion apparatus, and determine that the charging control unit can correctly respond to the charging request in a case that the first charging request information is the same as the second charging request information, thus improving the reliability of the storage and charging system.

In some embodiments of the present disclosure, after determining that the charging control unit passes charging request response testing in a case that the first charging request information is the same as the second charging request information, the method further includes:
acquiring a first charging capacity parameter transmitted by the energy management system and received by the charging control unit, where the first charging capacity parameter is calculated by the energy management system based on a charging capacity parameter of the energy storage apparatus and a charging capacity parameter of the AC-DC converter that are received; and
determining that charging capacity parameter match testing passes in a case that the first charging capacity parameter is the same as the second charging capacity parameter, where the second charging parameter represents a charging capacity parameter calculated based on a measured charging capacity parameter of the energy storage apparatus and a measured charging capacity parameter of the AC-DC converter.

In this embodiment, after the charging control unit passes charging request response testing, charging capacity parameter match testing may be performed. The tester may acquire a first charging capacity parameter received by the charging control unit from the energy management system, where the first charging capacity parameter is calculated by the energy management system based on a charging capacity parameter of the energy storage apparatus and a charging capacity parameter of the AC-DC converter that are acquired by the energy management system, then measure the charging capacity parameter of the energy storage apparatus and the charging capacity parameter of the AC-DC converter to obtain a measured second charging capacity parameter, and determine that charging capacity parameter match testing passes in a case that the first charging capacity parameter is the same as the second charging capacity parameter, thus improving the charging reliability of the storage and charging system.

In some embodiments of the present disclosure, after determining that charging capacity parameter match testing passes in a case that the first charging capacity parameter is the same as the second charging capacity parameter, the method further includes:
acquiring an output parameter of the charging conversion apparatus transmitted by the charging control unit in a case that the device to be charged is charged through the charging conversion apparatus; and
determining that the charging conversion apparatus passes output parameter testing in a case that the output parameter is less than or equal to a target parameter, where the target parameter is the minimum value in the first charging request information and the first charging capacity parameter.

In this embodiment, after charging capacity parameter match testing passes, the output parameter of the charging conversion apparatus may also be tested. The tester may acquire an output parameter of the charging conversion apparatus in a process of charging the device to be charged by using the charging conversion apparatus through the charging control unit, compare the output parameter with a target parameter, where the target parameter is the minimum value in the first charging request information and the first charging capacity parameter, and determine that the charging conversion apparatus passes output parameter testing in a case that the output parameter is less than or equal to the target parameter, thus improving the charging reliability of the storage and charging system.

In some embodiments of the present disclosure, after determining that the charging conversion apparatus passes output parameter testing in a case that the output parameter is less than or equal to a target parameter, the method further includes:
acquiring a first discharging parameter of the AC-DC converter in a case that the device to be charged is charged through the AC-DC converter;
acquiring a second discharging parameter of the energy storage apparatus in a case that the device to be charged is charged through the energy storage apparatus;
acquiring a third discharging parameter of the AC-DC converter and a fourth discharging parameter of the energy storage apparatus in a case that the device to be charged is charged through the AC-DC converter and the energy storage apparatus; and
determining that the AC-DC converter and the energy storage apparatus pass discharging parameter testing in a case that the first discharging parameter and the third discharging parameter are less than or equal to the charging capacity parameter of the AC-DC converter and the second discharging parameter and the fourth discharging parameter are less than or equal to the charging capacity parameter of the energy storage apparatus.

In this embodiment, after determining that the charging conversion apparatus passes output parameter testing, the discharging parameters of the AC-DC converter and the energy storage may also be tested. The tester may acquire a first discharging parameter of the AC-DC converter in a process of charging the device to be charged by using the AC-DC converter only; acquire a second discharging parameter of the energy storage apparatus in a process of charging the device to be charged by using the energy storage apparatus only; acquire a third discharging parameter of the AC-DC converter and a fourth discharging parameter of the energy storage apparatus in a process of charging the device to be charged by using the AC-DC converter and the energy storage apparatus at the same time; then determine whether the discharging parameters of the AC-DC converter, including the first discharging parameter and the third discharging parameter, are both less than or equal to the charging capacity parameter of the AC-DC converter, and whether the discharging parameters of the energy storage apparatus, including the second discharging parameter and the fourth discharging parameter, are both less than or equal to the charging capacity parameter of the energy storage apparatus; determine that the AC-DC converter and the energy storage apparatus pass discharging parameter testing in a case that the discharging parameters all satisfy the conditions, thus improving the stability of the storage and charging system when charging the device to be charged through the three charging methods.

In some embodiments of the present disclosure, the charging conversion apparatus includes at least two DC-DC converters connected in parallel; the method further includes:
acquiring respective output data of the at least two DC-DC converters in a case that power is supplied to the device to be charged through the charging conversion apparatus;
determining output difference information based on the output data, where the output difference information represents difference information between currents respectively outputted by the at least two DC-DC converters; and
determining that the charging conversion apparatus passes circulating current testing in a case that the output difference information is less than or equal to a second threshold.

In this embodiment, circulating current testing may also be performed on the at least two parallel DC-DC converters in the charging conversion apparatus. The tester may acquire respective output data of the at least two DC-DC converters in a process of supplying power to the device to be charged through the charging conversion apparatus, determine output difference information between currents outputted by the at least two DC-DC converters based on the output data, and determine that the charging conversion apparatus passes circulating current testing in a case that the output difference information is less than or equal to a second threshold, thus improving the balance when the at least two DC to DC converters in the charging conversion apparatus output currents.

In some embodiments of the present disclosure, the method further includes:
writing first software version information to the battery management unit, so that the battery management unit transmits the first software version information to the energy management system;
receiving second software version information transmitted by the energy management system; and
determining that the energy management system passes software version reading testing in a case that the first software version information is the same as the second software version information.

In this embodiment, software testing may also be performed on the storage and charging system after passing multiple hardware testing. The tester may write first software version information to the battery management unit, then acquire second software version information transmitted by the energy management system after the battery management unit transmits the first software version information to the energy management system, and determine that the energy management system pass software version reading testing in a case that the first software version information is the same as the second software version information, thus improving the running stability of software in the storage and charging system.

In some embodiments of the present disclosure, the method further includes:
transmitting a high-voltage applying instruction to the energy management system;
determining that the energy storage apparatus passes high-voltage applying testing in a case that the energy management system controls the battery management unit to complete a high-voltage applying operation on the energy storage apparatus in response to the high-voltage applying instruction;
transmitting a high-voltage removal instruction to the energy management system; and
determining that the energy storage apparatus passes high-voltage removal testing in a case that the energy management system controls the battery management unit to complete a high-voltage removal operation on the energy storage apparatus in response to the high-voltage removal instruction.

In this embodiment, high-voltage applying testing and high-voltage removal testing may also be performed on the energy storage apparatus. The tester may transmit a high-voltage applying instruction to the energy management system to determine whether the energy management system can control the battery management unit to complete a high-voltage applying operation on the energy storage apparatus in response to the high-voltage applying instruction, determine that high-voltage applying testing passes in a case that the high-voltage applying operation can be completed, transmit a high-voltage removal instruction to the energy management system to determine whether the energy management system can control the battery management unit to complete a high-voltage removal operation on the energy storage apparatus in response to the high-voltage removal instruction, and determine that high-voltage removal testing passes in a case that the high-voltage removal operation can be completed. Thus improving the stability of the high-voltage applying and removal operations.

In some embodiments of the present disclosure, the method further includes:
acquiring state detection information of the battery management unit from the energy management system in a case that the energy storage apparatus is turned off; and
determining that the battery management unit passes offline function testing in a case that the state detection information is that the battery management unit is in an offline state.

In this embodiment, the tester may also acquire state detection information of the battery management unit from the energy management system in a case that the energy storage apparatus is turned off, to determine whether the energy management system can accurately detect that the battery management unit in the energy storage apparatus is in an offline state, thus achieving the effective testing of the offline function of the software in the battery management unit.

According to a second aspect, an embodiment of the present disclosure provides a testing system, including a tester and a storage and charging system connected with the tester, where the storage and charging system includes an energy management system, an energy storage apparatus, and a charging conversion apparatus; the energy storage apparatus includes a battery management unit; the charging conversion apparatus is respectively connected with an AC-DC converter and the energy storage apparatus.

The tester is configured to acquire first charging data about that the energy management system controls an AC-DC converter to charge the energy storage apparatus in a case that the remaining power of the energy storage apparatus is less than or equal to a first threshold, and determine whether an energy storage function of the storage and charging system is normal based on the first charging data.

The tester is further configured to acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data, where the energy storage function and the charging function are tested in a case that a communication function between the battery management unit and the energy management system passes testing; the testing of the communication function is completed based on message data received by the energy management system and message data transmitted by the battery management unit.

In this embodiment, when the energy storage function of the storage and charging system is normal, the energy management system may instruct the AC-DC converter to charge the energy storage apparatus in a case that the remaining power of the energy storage apparatus is less than or equal to the first threshold. Therefore, when the tester tests the energy storage function, it may acquire first charging data about that the energy management system instructs the AC-DC converter to charge the energy storage apparatus in a case that the remaining power of the energy storage apparatus is less than or equal to the first threshold, to determine whether the energy storage function of the storage and charging system is normal based on the first charging data, that is, determine whether the storage and charging system can automatically charge the energy storage apparatus in a case that the remaining power of the energy storage apparatus is less than or equal to the first threshold. For the charging function of the storage and charging system, under normal circumstances, three charging methods may be supported, including charging the device to be charged by using the AC-DC converter only, charging the device to be charged by using the energy storage apparatus only, and charging the device to be charged by using the AC-DC converter and the energy storage apparatus at the same time. Therefore, when the tester tests the charging function of the storage and charging system, the tester may acquire second charging data about that the energy management system controls the AC-DC converter and/or the energy storage apparatus to charge the device to be charged in a case that the device to be charged is connected, to determine whether the storage and charging system can normally execute the three charging methods based on the second charging data, thus achieving the effective testing of the automatic energy storage function and charging function of the storage and charging system. In addition, before the energy storage function and the charging function are tested, the communication function between the battery management unit and the energy management system may also be tested based on message data received by the energy management system and message data transmitted by the battery management unit, to ensure that the communication function between the battery management unit and the energy management system is normal. Based on the above testing, the use reliability of the storage and charging system can be effectively improved.

### BRIEF DESCRIPTION OF THE DRAWINGS

By reading the detailed description of the preferred implementations below, various other advantages and benefits will become apparent to those of ordinary skill in the art. The drawings are for the purpose of illustrating the preferred implementations only and are not to be considered a limitation to the present disclosure.
FIG. 1 is a schematic flowchart of a testing method for a storage and charging system according to an embodiment of the present disclosure;
FIG.2 is a schematic structural diagram I of components of a testing system according to an embodiment of the present disclosure;
FIG. 3 is a schematic structural diagram of components a storage and charging system according to an embodiment of the present disclosure;
FIG. 4 is a schematic structural diagram II of components of a testing system according to an embodiment of the present disclosure.

### DETAILED DESCRIPTION

The following clearly and completely describes the technical solutions in the embodiments of the present disclosure with reference to the accompanying drawings in the embodiments of the present disclosure. It may be understood that specific embodiments described herein are intended only to explain the relevant application, but not to limit this application. It should also be noted that, for convenience of description, only parts relevant to the related application are shown in the drawings.

The application of new energy batteries in daily life and industry is becoming increasingly widespread. For example, new energy vehicles equipped with batteries have been widely applied. In addition, batteries are also being increasingly applied in the field of energy storage. New energy batteries are not only applied to energy storage power source systems such as hydraulic, thermal, wind and solar power stations, but also widely applied to electric vehicles such as electric bicycles, electric motorcycles and electric cars, as well as aerospace. With the continuous expansion of the application field of power batteries, the market demand is also constantly expanding. For example, they can be applied to integrated storage and charging systems.

At present, with the gradual application of integrated storage and charging systems, how to fully test the integrated storage and charging systems before they are put into market use to ensure that they can operate normally after being put into use is an urgent problem to be solved.

In order to solve the problems existing in the testing of the existing storage and charging system, an embodiment of the present disclosure provides a testing method and a testing system for a storage and charging system. The testing system may include a tester and a storage and charging system. The storage and charging system may include an energy management system, an energy storage apparatus, and a charging conversion apparatus. The energy storage apparatus includes a battery management unit. The tester may acquire first charging data about that the energy management system instructs an AC-DC converter to charge the energy storage apparatus in a case that the remaining power of the energy storage apparatus is less than or equal to a first threshold, and determine whether an energy storage function of the storage and charging system is normal based on the first charging data; acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal. The energy storage function and the charging function are tested in a case that a communication function between the battery management unit and the energy management system passes testing. The testing of the communication function is completed based on message data received by the energy management system and message data transmitted by the battery management unit, thus achieving the effective testing the function of the storage and charging system and improving the use reliability of the storage and charging system.

The following clearly and completely describes the technical solutions in the embodiments of the present disclosure with reference to the accompanying drawings in the embodiments of the present disclosure.

The description of the system in the embodiment of the present disclosure is similar to the following description of the method embodiment, and has similar beneficial effects as the method embodiment. For technical details not disclosed in the system embodiment, please refer to the description of the method embodiment of the present disclosure for understanding.

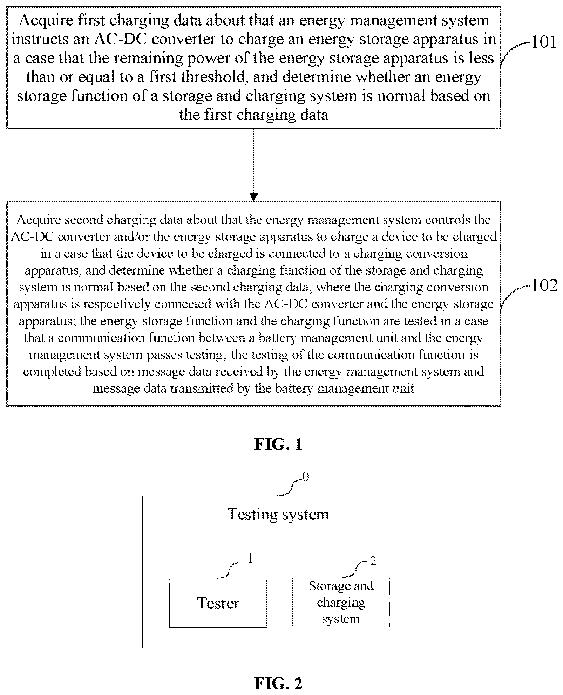

An embodiment of the present disclosure provides a testing method for a storage and charging system, applied to a tester in a testing system. The testing system further includes the storage and charging system. The storage and charging system may include an energy management system, an energy storage apparatus, and a charging conversion apparatus. Referring to FIG. 1, the testing method for the storage and charging system by using the tester may include the following steps:
In Step 101,first charging data about that the energy management system instructs an AC-DC converter to charge the energy storage apparatus is acquired in a case that the remaining power of the energy storage apparatus is less than or equal to a first threshold, and whether an energy storage function of the storage and charging system is normal is determined based on the first charging data.

In this embodiment of the present disclosure, the tester may acquire first charging data about that the Energy Management System (EMS) instructs an AC-DC converter to charge the energy storage apparatus in a case that the remaining power of the energy storage apparatus is less than or equal to a first threshold, and determine whether an energy storage function of the storage and charging system is normal based on the first charging data.

In this embodiment of the present disclosure, the tester may be an upper computer configured to transmit a control instruction and has a screen display function.

In this embodiment of the present disclosure, the energy storage apparatus may include multiple batteries. Each battery may be formed by one or more battery cores through assembling. The battery may be a cell. The cell refers to a basic unit that can realize mutual conversion between chemical energy and electrical energy, and may be used to make a battery module or a battery pack to supply power to an electrical apparatus. The cell may be a secondary battery, and the secondary battery refers to a cell that can be used continually by activating an active material in a charging method after the cell is discharged. The cell may be a lithium-ion battery, a sodium-ion battery, a sodium-lithium-ion battery, a lithium-metal battery, a sodium-metal battery, a lithium-sulfur battery, a magnesium-ion battery, a nickel-metal hydride battery, a nickel-cadmium battery, a lead storage battery, and so forth, which is not limited in this embodiment of the present disclosure.

In this embodiment of the present disclosure, the battery may also be a single physical module including one or more cells to provide a higher voltage and capacity. In a case that there are multiple cells, the multiple cells are in series connection, parallel connection, or parallel-series connection through a bus component.

In this embodiment of the present disclosure, the remaining power of the battery may be determined according to the State of Charge (SOC) of the battery, or the remaining power of the energy storage apparatus may be determined based on the SOC of each battery in the energy storage apparatus.

In this embodiment of the present disclosure, the value of the first threshold is not limited in the present disclosure. For example, the first threshold may be 5%. In a case that the remaining power of the energy storage apparatus is 5% or less, it may be determined that the energy storage apparatus is in a low power state, and the storage and charging system may automatically charge the energy storage apparatus. That is to say, the storage and charging system in the present disclosure has the function of automatically recharging the energy storage apparatus.

In this embodiment of the present disclosure, the AC-DC converter may be a bidirectional AC-DC converter, i.e., a bidirectional Alternating Current (AC)/Direct Current (DC) converter. The number of the bidirectional AC-DC converter is not limited in the present disclosure and may be at least one. The testing system further includes a DC bus. One end of the AC-DC converter may be connected to the DC bus, and the other end may be connected to a transformer. The transformer may be connected to the power grid to output AC power to the AC-DC converter through the power grid.

In this embodiment of the present disclosure, the first charging data may be configured to describe the process of charging the energy storage apparatus through the AC-DC converter. The first charging data may include state information of various apparatuses in the storage and charging system in the process of charging the energy storage apparatus through the AC-DC converter, and information such as current, voltage, and power in the charging process.

In some embodiments of the present disclosure, the tester may determine that the energy storage function of the storage and charging system is normal in a case that it is determined that the charging process is normal and each apparatus has no fault based on the state information of each apparatus in the first charging data.

In this embodiment of the present disclosure, charging the energy storage apparatus through the AC-DC converter means acquiring electrical energy from the power grid to charge the energy storage apparatus.

In Step 102, second charging data about that the energy management system controls the AC-DC converter and/or the energy storage apparatus to charge the device to be charged is acquired in a case that the device to be charged is connected to the charging conversion apparatus, and whether a charging function of the storage and charging system is normal is determined based on the second charging data, where the charging conversion apparatus is respectively connected with the AC-DC converter and the energy storage apparatus; the energy storage function and the charging function are tested in a case that a communication function between the battery management unit and the energy management system passes testing; the testing of the communication function is completed based on message data received by the energy management system and message data transmitted by the battery management unit.

In this embodiment of the present disclosure, the tester may acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data, where the charging conversion apparatus is respectively connected with the AC-DC converter and the energy storage apparatus; the energy storage function and the charging function are tested in a case that a communication function between the battery management unit and the energy management system passes testing; the testing of the communication function is completed based on message data received by the energy management system and message data transmitted by the battery management unit.

In this embodiment of the present disclosure, the sequence of performing the testing of the energy storage function and the charging function is not limited in the present disclosure. The testing of the charging function may be performed after the testing of the energy storage function, or the testing of the energy storage function may be performed after the testing of the charging function.

In this embodiment of the present disclosure, the device to be charged refers to a device that is connected to the storage and charging system for charging. The device to be charged is not limited in the present disclosure. For example, it may be an electric vehicle.

In this embodiment of the present disclosure, the charging conversion apparatus may include at least two DC-DC converters, i.e., bidirectional DC/DC converters. The number of the bidirectional DC/DC converters is not limited in the present disclosure. For example, it may include eight bidirectional DC/DC converters. The charging conversion apparatus may further include a Charging Control Unit (CCU). The charging control unit may be configured to control the charging conversion apparatus.

In this embodiment of the present disclosure, the energy storage apparatus may include a Battery Management System (BMS). The battery management unit may be configured to control the energy storage apparatus.

In this embodiment of the present disclosure, the energy management system may be configured to control various apparatuses or sub-modules in the storage and charging system. For example, the energy management system may be configured to control the battery management unit and the charging control unit to achieve the control over the energy storage apparatus and the charging conversion apparatus.

In some embodiments of the present disclosure, the second charging data may be configured to describe the process of charging the device to be charged through the AC-DC converter and/or energy storage apparatus. The second charging data may include state information of various apparatuses in the storage and charging systemin the process of charging the device to be charged through the AC-DC converter and/or energy storage apparatus, and information such as current, voltage, and power in the charging process.

In some embodiments of the present disclosure, the second charging data may include third charging information, fourth charging information, and fifth charging information.

In some embodiments of the present disclosure, the tester may transmit first charging instruction information to the energy management system, so that the energy management system controls the AC-DC converter to charge the device to be charged in response to the first charging instruction information, and acquires the third charging information, where the first charging instruction information is configured to instruct to charge the device to be charged through the AC-DC converter.

In this embodiment of the present disclosure, charging the device to be charged through the AC-DC converter means acquiring electrical energy from the power grid to charge the device to be charged.

In this embodiment of the present disclosure, when testing the charging method of charging the device to be charged only through the AC-DC converter, the tester may transmit first charging instruction information to the energy management system to shield the energy storage apparatus and charge the device to be charged only through the AC-DC converter.

In this embodiment of the present disclosure, the third charging information may be configured to describe the process of charging the device to be charged through the AC-DC converter. The third charging information may include state information of various apparatuses in the storage and charging systemin the process of charging the device to be charged through the AC-DC converter, and information such as current, voltage, and power in the charging process.

In some embodiments of the present disclosure, the tester may transmit second charging instruction information to the energy management system, so that the energy management system controls the energy storage apparatus through the battery management unit to charge the device to be charged in response to the second charging instruction information, and acquires the fourth charging information.

In this embodiment of the present disclosure, the second charging instruction information is configured to instruct to charge the device to be charged through the energy storage apparatus.

In some embodiments of the present disclosure, it may be determined that the charging method of charging the device to be charged through the AC-DC converter passes testing in a case that it is determined based on the third charging information that each apparatus in the storage and charging system has not fault in the process of charging the device to be charged through the AC-DC converter, and the current, voltage, and power in the charging process do not exceed respective load values.

In this embodiment of the present disclosure, when testing the charging method of charging the device to be charged only through the energy storage apparatus, the tester may transmit second charging instruction information to the energy management system to shield the AC-DC converter and charge the device to be charged only through the energy storage apparatus.

In this embodiment of the present disclosure, the fourth charging information may be configured to describe the process of charging the device to be charged through the energy storage apparatus. The fourth charging information may include state information of various apparatuses in the storage and charging systemin the process of charging the device to be charged through the energy storage apparatus, and information such as current, voltage, and power in the charging process.

In some embodiments of the present disclosure, it may be determined that the charging method of charging the device to be charged through the energy storage apparatus passes testing in a case that it is determined based on the fourth charging information that each apparatus in the storage and charging system has not fault in the process of charging the device to be charged through the energy storage apparatus, and the current, voltage, and power in the charging process do not exceed respective load values.

In some embodiments of the present disclosure, the tester may transmit third charging instruction information to the energy management system, so that the energy management system controls the AC-DC converter and the battery management unit in response to the first charging instruction information to charge the device to be charged through the AC-DC converter and the energy storage apparatus, and acquires the fifth charging information.

In this embodiment of the present disclosure, the third charging instruction information is configured to instruct to charge the device to be charged through the AC-DC converter and the energy storage apparatus.

In this embodiment of the present disclosure, the fifth charging information may be configured to describe the process of charging the device to be charged through the AC-DC converter and the energy storage apparatus. The fifth charging information may include state information of various apparatuses in the storage and charging systemin the process of charging the device to be charged through the AC-DC converter and the energy storage apparatus, and information such as current, voltage, and power in the charging process.

In some embodiments of the present disclosure, it may be determined that the charging method of charging the device to be charged through the AC-DC converter and the energy storage apparatus passes testing in a case that it is determined based on the fifth charging information that each apparatus in the storage and charging system has not fault in the process of charging the device to be charged through the AC-DC converter and the energy storage apparatus, and the current, voltage, and power in the charging process do not exceed respective load values.

In this embodiment of the present disclosure, the energy storage apparatus may include a battery management unit; the testing method for the storage and charging system by using the tester may further include the following steps:
In Step 201, first message data of the energy management system and second message data of the battery management unit are acquired before the energy storage function and the charging function are tested, where the second message data represents message data generated by the battery management unit and transmitted to the energy management system, and the first message data represents message data received by the energy management system from the battery management unit.

In this embodiment of the present disclosure, the tester may acquire first message data of the energy management system and second message data of the battery management unit before the energy storage function and the charging function are tested, where the second message data represents message data generated by the battery management unit and transmitted to the energy management system, and the first message data represents message data received by the energy management system from the battery management unit.

In some embodiments of the present disclosure, the testing of the energy storage function and the testing of the charging function are both part of the testing items of the entire storage and charging system. Before the testing items are performed, hardware testing and software testing are required. The testing of the communication function is a hardware testing item.

In some embodiments of the present disclosure, when testing the communication function of the storage and charging system, the tester may test the communication function between the battery management unit and the energy management system.

In some embodiments of the present disclosure, it may be directly determined that the testing of the communication function between the battery management unit and the energy management system does not pass in a case that the battery management unit is unable to transmit message data to the energy management system.

In Step 202, the first message data and the second message data are compared to obtain a comparison result.

In this embodiment of the present disclosure, after acquiring the first message data of the energy management system and the second message data of the battery management unit, the tester may compare the first message data and the second message data to obtain a comparison result.

In Step 203, it is determined that the communication function between the battery management unit and the energy management system passes testing in a case that the comparison result is that the first message data is the same as the second message data.

In this embodiment of the present disclosure, after the tester compares the first message data and the second message data to obtain the comparison result, it may be determined that the communication function between the battery management unit and the energy management system passes testing in a case that the comparison result is that the first message data is the same as the second message data.

In this embodiment of the present disclosure, it may be determined that the testing of the communication function between the battery management unit and the energy management system does not pass in a case that the comparison result is that the first message data is different from the second message data.

In this embodiment of the present disclosure, after the tester determines that the communication function between the battery management unit and the energy management system passes testing in a case that the comparison result is that the first message data is the same as the second message data, i.e., after Step 203, the method may further include the following steps:
In Step 301, a protection instruction generated by the energy management system in response to a fault message transmitted by the battery management unit is acquired.

In this embodiment of the present disclosure, after determining that the communication function between the battery management unit and the energy management system passes testing in a case that the comparison result is that the first message data is the same as the second message data, the tester may further acquire a protection instruction generated by the energy management system in response to a fault message transmitted by the battery management unit.

In this embodiment of the present disclosure, the fault message may correspond to a fault level of the battery management unit. The battery management unit may have faults of Level 1 to Level 7, that is, the fault level may be any one of Level 1 to Level 7. Therefore, the generated fault message may include first level information for indicating the fault level.

In this embodiment of the present disclosure, the protection instruction is configured to instruct the storage and charging system to perform a protection measure of the corresponding level. The protection instruction may include second level information for indicating the fault level.

In Step 302, the fault message of the battery management unit is acquired and a fault level of the fault message is determined.

In this embodiment of the present disclosure, after acquiring the protection instruction generated by the energy management system in response to the fault message transmitted by the battery management unit, the tester may acquire the fault message of the battery management unit and determine a fault level of the fault message.

In Step 303, it is determined that a protection function of the energy storage apparatus passes testing in a case that the protection instruction is a protection instruction corresponding to the fault level.

In this embodiment of the present disclosure, after acquiring the fault message of the battery management unit and determining the fault level of the fault message, the tester may determine that a protection function of the energy storage apparatus passes testing in a case that the protection instruction is a protection instruction corresponding to the fault level.

Exemplarily, if the battery management unit has a fault of Level 2, generates a corresponding fault message and transmits it to the energy management system, and the energy management system triggers a protection instruction corresponding to the fault of Level 2 in response to the fault message, it will be determined that the protection function of the energy storage apparatus passes testing.

In some embodiments of the present disclosure, the tester may also perform testing on a protection function of the storage and charging system. In the process of charging the energy storage apparatus, the tester may trigger the fault of the battery management unit, and determine that a protection function in the process of charging the energy storage apparatus passes testing in a case that trigger information about that the energy management system triggers a corresponding protection measure is received.

Exemplarily, in the process of charging the energy storage apparatus, the fault of the battery management unit may include cell over-voltage, system over-voltage, over-current, cell over-temperature, system over-temperature, SOC exceeding an upper limit, etc.

In some embodiments of the present disclosure, the tester may also trigger a fault of the battery management unit in the process of charging the device to be charged by using the storage and charging system, and determine that a protection function in the process of charging the device to be charged passes testing in a case that trigger information about that the energy management system triggers a corresponding protection measure is received.

Exemplarily, in the process of charging the device to be charged by using the storage and charging system, the fault of the battery management unit may include cell under-voltage, system under-voltage, cell over-temperature, system over-temperature, SOC exceeding a lower limit, etc.

In some embodiments of the present disclosure, the storage and charging system may further include a liquid cooling module and a fire protection module; when the energy management system receives a fault message, it can control all devices or sub-modules in the storage and charging system, including the liquid cooling module and the fire protection module, to execute corresponding protection measures.

In some embodiments of the present disclosure, after the tester determines that the communication function between the battery management unit and the energy management system passes testing in a case that the comparison result is that the first message data is the same as the second message data, i.e., after Step 203, the method may further include the following steps:
In Step 401, first voltage data of the energy storage apparatus at different levels of remaining power and second voltage data of a battery in the energy storage apparatus are acquired.

In this embodiment of the present disclosure, after determining that the communication function between the battery management unit and the energy management system passes testing in a case that the comparison result is that the first message data is the same as the second message data, the tester may acquire first voltage data of the energy storage apparatus at different levels of remaining power and second voltage data of a battery in the energy storage apparatus.

In some embodiments of the present disclosure, the hardware testing item may further include voltage testing of the energy storage apparatus.

In this embodiment of the present disclosure, the first voltage data may include voltage data of the energy storage apparatus at different levels of remaining power.

In this embodiment of the present disclosure, the second voltage data may include voltage data of each battery in the energy storage apparatus at different levels of remaining power.

In Step 402, it is determined that the voltage of the energy storage apparatus passes testing in a case that the first voltage data conforms to a first voltage range and the second voltage data conforms to a second voltage range.

In this embodiment of the present disclosure, after acquiring the first voltage data of the energy storage apparatus at different levels of remaining power and the second voltage data of the battery in the energy storage apparatus, the tester may determine that the voltage of the energy storage apparatus passes testing in a case that the first voltage data conforms to a first voltage range and the second voltage data conforms to a second voltage range.

In this embodiment of the present disclosure, the first voltage range may include a voltage range for measuring the voltage of the energy storage apparatus at different levels of remaining power, and its value is not limited in the present disclosure. For example, the first voltage range may include a voltage range of a1 to b1 for measuring the voltage of the energy storage apparatus when the SOC of the energy storage apparatus is 10%, and a voltage range of a2 to b2 for measuring the voltage of the energy storage apparatus when the SOC of the energy storage apparatus is 50%.

In this embodiment of the present disclosure, the second voltage range may include a voltage range for measuring the voltage of the battery in the energy storage apparatus at different levels of remaining power, and its value is not limited in the present disclosure. For example, the second voltage range may include a voltage range of a3 to b3 for measuring the voltage of the battery in the energy storage apparatus when the SOC of the energy storage apparatus is 10%, and a voltage range of a4 to b4 for measuring the voltage of the battery in the energy storage apparatus when the SOC of the energy storage apparatus is 50%.

Exemplarily, the tester may determine that the voltage of the energy storage apparatus passes testing in a case that the voltage acquired is c1 when the SOC of the energy storage apparatus is 10%, a1<c1<b1, the voltage acquired is c2 when the SOC of the energy storage apparatus is 50%, a2<c2<b2, the voltage acquired is c3 when the SOC of the energy storage apparatus is 10%, a3<c3<b3, and the internal battery voltage is c4 when the SOC of the energy storage apparatus is 50%, and a4<c4<b4.

In this embodiment of the present disclosure, the charging conversion apparatus may include a charging control unit; the testing method for the storage and charging system by using the tester may further include the following steps:
In Step 501, first charging request information of the device to be charged in a case that the device to be charged is connected to the charging conversion apparatus, and second charging request information transmitted by the device to be charged and received by the charging control unit are acquired.

In this embodiment of the present disclosure, the tester may acquire first charging request information of the device to be charged in a case that the device to be charged is connected to the charging conversion apparatus, and second charging request information transmitted by the device to be charged and received by the charging control unit.

In this embodiment of the present disclosure, the hardware testing item may further include charging request response testing of the charging control unit.

In this embodiment of the present disclosure, the first charging request information may include information about the charging current, power, and voltage requested by the device to be charged.

In this embodiment of the present disclosure, the second charging request information represents charging request information transmitted by the device to be charged and received by the charging control unit.

In Step 502, it is determined that the charging control unit passes charging request response testing in a case that the first charging request information is the same as the second charging request information.

In this embodiment of the present disclosure, after acquiring the first charging request information of the device to be charged in a case that the device to be charged is connected to the charging conversion apparatus, and the second charging request information transmitted by the device to be charged and received by the charging control unit, the tester may determine that the charging control unit passes charging request response testing in a case that the first charging request information is the same as the second charging request information.

In some embodiments of the present disclosure, after the tester determines that the charging control unit passes charging request response testing in a case that the first charging request information is the same as the second charging request information, i.e., after Step 502, the method may further include the following steps:
In Step 601, a first charging capacity parameter transmitted by the energy management system and received by the charging control unit is acquired, where the first charging capacity parameter is calculated by the energy management system based on a charging capacity parameter of the energy storage apparatus and a charging capacity parameter of the AC-DC converter that are received.

In this embodiment of the present disclosure, after determining that the charging control unit passes charging request response testing in a case that the first charging request information is the same as the second charging request information, the tester may acquire a first charging capacity parameter transmitted by the energy management system and received by the charging control unit, where the first charging capacity parameter is calculated by the energy management system based on a charging capacity parameter of the energy storage apparatus and a charging capacity parameter of the AC-DC converter that are received.

In some embodiments of the present disclosure, the hardware testing item may further include charging capacity parameter match testing.

In some embodiments of the present disclosure, the energy management system may perform an addition operation on the charging capacity parameter of the energy storage apparatus and the charging capacity parameter of the AC-DC converter that are received to obtain the first charging capacity parameter.

In this embodiment of the present disclosure, the charging capacity parameter of the energy storage apparatus represents the maximum charging capacity supportable by the energy storage apparatus.

In this embodiment of the present disclosure, the charging capacity parameter of the AC-DC converter represents the maximum charging capacity supportable by the AC-DC converter.

In Step 602, it is determined that charging capacity parameter match testing passes in a case that the first charging capacity parameter is the same as the second charging capacity parameter, where the second charging parameter represents a charging capacity parameter calculated based on a measured charging capacity parameter of the energy storage apparatus and a measured charging capacity parameter of the AC-DC converter.

In this embodiment of the present disclosure, after acquiring the first charging capacity parameter transmitted by the energy management system and received by the charging control unit, the tester may determine that charging capacity parameter match testing passes in a case that the first charging capacity parameter is the same as the second charging capacity parameter, where the second charging parameter represents a charging capacity parameter calculated based on a measured charging capacity parameter of the energy storage apparatus and a measured charging capacity parameter of the AC-DC converter.

In some embodiments of the present disclosure, the tester may perform an addition operation on the measured charging capacity parameter of the energy storage apparatus and the measured charging capacity parameter of the AC-DC converter to obtain the second charging capacity parameter.

In some embodiments of the present disclosure, it is determined that charging capacity parameter match testing does not pass in a case that the first charging capacity parameter is the same as the second charging capacity parameter.

In some embodiments of the present disclosure, after the tester determines that the charging capacity parameter match testing passes in a case that the first charging capacity parameter is the same as the second charging capacity parameter, i.e., after Step 602, the method may further include the following steps:
In Step 701, an output parameter of the charging conversion apparatus transmitted by the charging control unit is acquired in a case that the device to be charged is charged through the charging conversion apparatus.

In this embodiment of the present disclosure, after determining that charging capacity parameter match testing passes in a case that the first charging capacity parameter is the same as the second charging capacity parameter, the tester may acquire an output parameter of the charging conversion apparatus transmitted by the charging control unit in a case that the device to be charged is charged through the charging conversion apparatus.

In some embodiments of the present disclosure, the hardware testing item may further include output parameter testing.

In this embodiment of the present disclosure, the output parameter may include information about the charging current, power, and voltage outputted through the charging conversion apparatus.

In Step 702, it is determined that the charging conversion apparatus passes output parameter testing in a case that the output parameter is less than or equal to a target parameter, where the target parameter is the minimum value in the first charging request information and the first charging capacity parameter.

In this embodiment of the present disclosure, after acquiring the output parameter of the charging conversion apparatus transmitted by the charging control unit in a case that the device to be charged is charged through the charging conversion apparatus, the tester may determine that the charging conversion apparatus passes output parameter testing in a case that the output parameter is less than or equal to a target parameter, where the target parameter is the minimum value in the first charging request information and the first charging capacity parameter.

In some embodiments of the present disclosure, after the tester determine that the charging conversion apparatus passes output parameter testing in a case that the output parameter is less than or equal to the target parameter, i.e., Step 702, the method may further include the following steps:
In Step 801, a first discharging parameter of the AC-DC converter is acquired in a case that the device to be charged is charged through the AC-DC converter.

In this embodiment of the present disclosure, after determining that the charging conversion apparatus passes output parameter testing in a case that the output parameter is less than or equal to the target parameter, the method further includes, the tester may acquire a first discharging parameter of the AC-DC converter in a case that the device to be charged is charged through the AC-DC converter.

In this embodiment of the present disclosure, the first discharging parameter may include information about the discharging current, voltage, and power in the process of charging the device to be charged through the AC-DC converter.

In Step 802, a second discharging parameter of the energy storage apparatus is acquired in a case that the device to be charged is charged through the energy storage apparatus.

In this embodiment of the present disclosure, the tester may acquire a second discharging parameter of the energy storage apparatus in a case that the device to be charged is charged through the energy storage apparatus.

In this embodiment of the present disclosure, the second discharging parameter may include information about the discharging current, voltage, and power in the process of charging the device to be charged through the energy storage apparatus.

In Step 803, a third discharging parameter of the AC-DC converter and a fourth discharging parameter of the energy storage apparatus are acquired in a case that the device to be charged is charged through the AC-DC converter and the energy storage apparatus.

In this embodiment of the present disclosure, the tester may acquire a third discharging parameter of the AC-DC converter and a fourth discharging parameter of the energy storage apparatus in a case that the device to be charged is charged through the AC-DC converter and the energy storage apparatus.

In this embodiment of the present disclosure, the fourth discharging parameter may include information about the discharging current, voltage, and power in the process of charging the device to be charged through the AC-DC converter and the energy storage apparatus.

In Step 804, it is determined that the AC-DC converter and the energy storage apparatus pass discharging parameter testing in a case that the first discharging parameter and the third discharging parameter are less than or equal to the charging capacity parameter of the AC-DC converter and the second discharging parameter and the fourth discharging parameter are less than or equal to the charging capacity parameter of the energy storage apparatus.

In this embodiment of the present disclosure, after acquiring the first discharging parameter of the AC-DC converter in a case that the device to be charged is charged through the AC-DC converter, acquiring the second discharging parameter of the energy storage apparatus in a case that the device to be charged is charged through the energy storage apparatus, and acquiring the third discharging parameter of the AC-DC converter and the fourth discharging parameter of the energy storage apparatus in a case that the device to be charged is charged through the AC-DC converter and the energy storage apparatus, the tester may determine that the AC-DC converter and the energy storage apparatus pass discharging parameter testing in a case that the first discharging parameter and the third discharging parameter are less than or equal to the charging capacity parameter of the AC-DC converter and the second discharging parameter and the fourth discharging parameter are less than or equal to the charging capacity parameter of the energy storage apparatus.

In this embodiment of the present disclosure, the charging conversion apparatus includes at least two DC-DC converters connected in parallel; the testing method for the storage and charging system by using the tester may further include the following steps:
In Step 901, respective output data of the at least two DC-DC converters are acquired in a case that power is supplied to the device to be charged through the charging conversion apparatus.

In this embodiment of the present disclosure, the tester may acquire respective output data of the at least two DC-DC converters in a case that power is supplied to the device to be charged through the charging conversion apparatus.

In this embodiment of the present disclosure, the hardware testing item may further include circulating current testing. Since the voltage of commonly used fast charging stations typically ranges from 120kW to 200kW and the power is low, no circulating current testing is required. Since at least two DC-DC converters are arranged in the charging conversion apparatus in this application and the power is high, such as 480kW, there may be a problem of current imbalance between the DC-DC converters. To verify the current balance performance, the tester may perform circulating current testing.

In this embodiment of the present disclosure, the output data may be related information about the current outputted by the DC-DC converter.

In Step 902, output difference information is determined based on the output data, where the output difference information represents difference information between currents respectively outputted by the at least two DC-DC converters.

In this embodiment of the present disclosure, after acquiring respective output data of the at least two DC-DC converters in a case that power is supplied to the device to be charged through the charging conversion apparatus, the tester may determine output difference information based on the output data, where the output difference information represents difference information between currents respectively outputted by the at least two DC-DC converters.

In Step 903, it is determined that the charging conversion apparatus passes circulating current testing in a case that the output difference information is less than or equal to a second threshold.

In this embodiment of the present disclosure, after determining the output difference information based on the output data, the tester may determine that the charging conversion apparatus passes circulating current testing in a case that the output difference information is less than or equal to a second threshold.

In this embodiment of the present disclosure, the value of the second threshold is not limited. For example, it may be 3%. It may be determined that the charging conversion apparatus passes circulating current testing in a case that the difference information between the currents outputted by the DC-DC converters is less than or equal to 3%.

In some embodiments of the present disclosure, it is determined that the charging conversion apparatus does not pass circulating current testing in a case that the output difference information is more than a second threshold.

In this embodiment of the present disclosure, the testing method for the storage and charging system by using the tester may further include the following steps:
In Step 1001, first software version information is written to the battery management unit, so that the battery management unit transmits the first software version information to the energy management system.

In this embodiment of the present disclosure, the tester may also write first software version information to the battery management unit, so that the battery management unit transmits the first software version information to the energy management system.

In some embodiments of the present disclosure, the first software version information may be the software version number of the battery management unit.

In Step 1002, second software version information transmitted by the energy management system is received.

In this embodiment of the present disclosure, after writing the first software version information to the battery management unit, so that the battery management unit transmits the first software version information to the energy management system, the tester may receive second software version information transmitted by the energy management system.

In this embodiment of the present disclosure, the second software version information represents the software version information received by the energy management system from the battery management unit.

In Step 1003, it is determined that the energy management system passes software version reading testing in a case that the first software version information is the same as the second software version information.

In this embodiment of the present disclosure, after receiving the second software version information transmitted by the energy management system, the tester may determine that the energy management system passes software version reading testing in a case that the first software version information is the same as the second software version information.

In this embodiment of the present disclosure, it is determined that the energy management system does not pass software version reading testing in a case that the first software version information is different from the second software version information.

In this embodiment of the present disclosure, the testing method for the storage and charging system by using the tester may further include the following steps:
In Step 1101, a high-voltage applying instruction is transmitted to the energy management system.

In this embodiment of the present disclosure, the tester may transmit a high-voltage applying instruction to the energy management system.

In Step 1102, it is determined that the energy storage apparatus passes high-voltage applying testing in a case that the energy management system controls the battery management unit to complete a high-voltage applying operation on the energy storage apparatus in response to the high-voltage applying instruction.

In this embodiment of the present disclosure, after transmitting the high-voltage applying instruction to the energy management system, the tester may determine that the energy storage apparatus passes high-voltage applying testing in a case that the energy management system controls the battery management unit to complete a high-voltage applying operation on the energy storage apparatus in response to the high-voltage applying instruction.

In this embodiment of the present disclosure, it may be determined that the energy storage apparatus does not pass high-voltage applying testing in a case that the energy management system does not control the battery management unit to complete the high-voltage applying operation on the energy storage apparatus after the tester transmits the high-voltage applying instruction to the energy management system.

In Step 1103, a high-voltage removal instruction is transmitted to the energy management system.

In this embodiment of the present disclosure, the tester may transmit a high-voltage removal instruction to the energy management system.

In Step 1104, it is determined that the energy storage apparatus passes high-voltage removal testing in a case that the energy management system controls the battery management unit to complete a high-voltage removal operation on the energy storage apparatus in response to the high-voltage removal instruction.

In this embodiment of the present disclosure, after transmitting the high-voltage removal instruction to the energy management system, the tester may determine that the energy storage apparatus passes high-voltage removal testing in a case that the energy management system controls the battery management unit to complete a high-voltage removal operation on the energy storage apparatus in response to the high-voltage removal instruction.

In this embodiment of the present disclosure, it may be determined that the energy storage apparatus does not pass high-voltage removal testing in a case that the energy management system does not control the battery management unit to complete the high-voltage removal operation on the energy storage apparatus after the tester transmits the high-voltage removal instruction to the energy management system.

In this embodiment of the present disclosure, the testing method for the storage and charging system by using the tester may further include the following steps:
In Step 1201, state detection information of the battery management unit is acquired from the energy management system in a case that the energy storage apparatus is turned off.

In this embodiment of the present disclosure, the tester may also acquire state detection information of the battery management unit from the energy management system in a case that the energy storage apparatus is turned off.

In this embodiment of the present disclosure, the state detection information may be configured to determine the state of the battery management unit, including an online state and an offline state.

In Step 1202, it is determined that the battery management unit passes offline function testing in a case that the state detection information is that the battery management unit is in an offline state.

In this embodiment of the present disclosure, after acquiring the state detection information of the battery management unit from the energy management system in a case that the energy storage apparatus is turned off, the tester may determine that the battery management unit passes offline function testing in a case that the state detection information is that the battery management unit is in an offline state.

In this embodiment of the present disclosure, after acquiring the state detection information of the battery management unit from the energy management system in a case that the energy storage apparatus is turned off, the tester may determine that the battery management unit does not pass offline function testing in a case that the state detection information is that the battery management unit is not in an offline state.

An embodiment of the present disclosure provides a testing method for a storage and charging system. When the energy storage function of the storage and charging system is normal, the energy management system may instruct the AC-DC converter to charge the energy storage apparatus in a case that the remaining power of the energy storage apparatus is less than or equal to the first threshold. Therefore, when the tester tests the energy storage function, it may acquire first charging data about that the energy management system instructs the AC-DC converter to charge the energy storage apparatus in a case that the remaining power of the energy storage apparatus is less than or equal to the first threshold, to determine whether the energy storage function of the storage and charging system is normal based on the first charging data, that is, determine whether the storage and charging system can automatically charge the energy storage apparatus in a case that the remaining power of the energy storage apparatus is less than or equal to the first threshold. For the charging function of the storage and charging system, under normal circumstances, three charging methods may be supported, including charging the device to be charged by using the AC-DC converter only, charging the device to be charged by using the energy storage apparatus only, and charging the device to be charged by using the AC-DC converter and the energy storage apparatus at the same time. Therefore, when the tester tests the charging function of the storage and charging system, it may acquire second charging data about that the energy management system controls the AC-DC converter and/or the energy storage apparatus to charge the device to be charged in a case that the device to be charged is connected, to determine whether the storage and charging system can normally execute the three charging methods based on the second charging data, thus achieving the effective testing of the automatic energy storage function and charging function of the storage and charging system. In addition, before the energy storage function and the charging function are tested, the communication function between the battery management unit and the energy management system may also be tested based on message data received by the energy management system and message data transmitted by the battery management unit, to ensure that the communication function between the battery management unit and the energy management system is normal. Based on the above testing, the use reliability of the storage and charging system can be effectively improved.

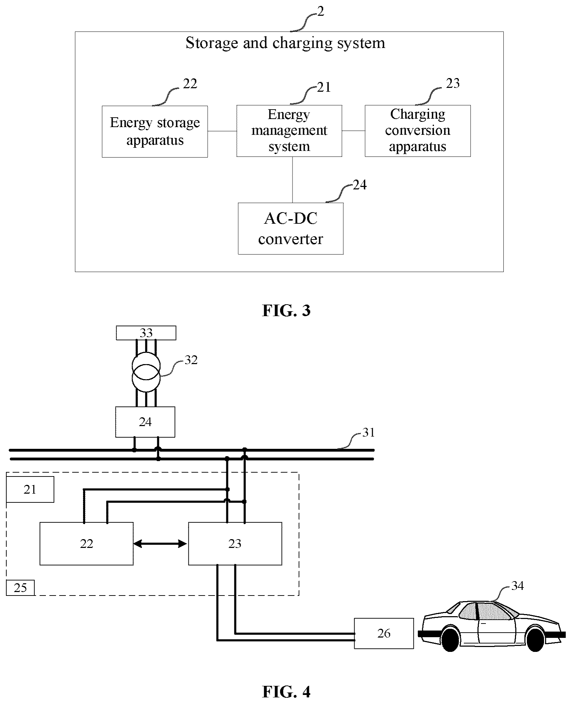

Based on the embodiment above, another embodiment of the present disclosure provides a testing system. Referring to FIG. 2, the testing system 0 includes a tester 1 and a storage and charging system 2 connected with the tester 1.Referring to FIG. 3, the storage and charging system 2 may include an energy management system 21, an energy storage apparatus 22, a charging conversion apparatus 23, and an AC-DC converter 24.

In this embodiment of the present disclosure, the charging conversion apparatus is respectively connected with the AC-DC converter and the energy storage apparatus.

The tester may be configured to acquire first charging data about that the energy management system controls an AC-DC converter to charge the energy storage apparatus in a case that the remaining power of the energy storage apparatus is less than or equal to a first threshold, and determine whether an energy storage function of the storage and charging system is normal based on the first charging data.

The tester may be further configured to acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data, where the energy storage function and the charging function are tested in a case that a communication function between the battery management unit and the energy management system passes testing; the testing of the communication function is completed based on message data received by the energy management system and message data transmitted by the battery management unit.

In this embodiment of the present disclosure, the energy storage apparatus may include a battery management unit; the charging conversion apparatus may include a charging control unit.

The battery management unit may be configured to control the energy storage apparatus to charge the device to be charged.

The charging control unit may be configured to control the charging conversion apparatus to output charging current to the device to be charged.

In this embodiment of the present disclosure, the storage and charging system may further include a charging gun; the charging gun is connected with the charging conversion apparatus; the AC-DC converter, the energy storage apparatus, and the charging conversion apparatus are connected to a DC bus.

In this embodiment of the present disclosure, the AC-DC converter may include an AC-DC converter.

In some embodiments of the present disclosure, the second charging data may include third charging information, fourth charging information, and fifth charging information; the tester may be further configured to transmit first charging instruction information to the energy management system, so that the energy management system controls the AC-DC converter to charge the device to be charged in response to the first charging instruction information, and acquires the third charging information, where the first charging instruction information is configured to instruct to charge the device to be charged through the AC-DC converter.

In some embodiments of the present disclosure, the tester may be further configured to transmit second charging instruction information to the energy management system, so that the energy management system controls the energy storage apparatus through the battery management unit to charge the device to be charged in response to the second charging instruction information, and acquires the fourth charging information, where the second charging instruction information is configured to instruct to charge the device to be charged through the energy storage apparatus.

In some embodiments of the present disclosure, the tester may be further configured to transmit third charging instruction information to the energy management system, so that the energy management system controls the AC-DC converter and the battery management unit in response to the first charging instruction information to charge the device to be charged through the AC-DC converter and the energy storage apparatus, and acquires the fifth charging information.

In some embodiments of the present disclosure, the tester may be further configured to acquire first message data of the energy management system and second message data of the battery management unit before the energy storage function and the charging function are tested, where the second message data represents message data generated by the battery management unit and transmitted to the energy management system, and the first message data represents message data received by the energy management system from the battery management unit; compare the first message data and the second message data to obtain a comparison result; and determine that the communication function between the battery management unit and the energy management system passes testing in a case that the comparison result is that the first message data is the same as the second message data.

In some embodiments of the present disclosure, the tester may be further configured to acquire a protection instruction generated by the energy management system in response to a fault message transmitted by the battery management unit; acquire the fault message of the battery management unit and determine a fault level of the fault message; and determine that a protection function of the energy storage apparatus passes testing in a case that the protection instruction is a protection instruction corresponding to the fault level.

In some embodiments of the present disclosure, the storage and charging system may further include a liquid cooling module and a fire protection module; when the energy management system receives a fault message, it can control all devices or sub-modules in the storage and charging system, including the liquid cooling module and the fire protection module, to execute corresponding protection measures.

In this embodiment of the present disclosure, the tester may be further configured to acquire first voltage data of the energy storage apparatus at different levels of remaining power and second voltage data of the battery in the energy storage apparatus; and determine that the voltage of the energy storage apparatus passes testing in a case that the first voltage data conforms to a first voltage range and the second voltage data conforms to a second voltage range.

In some embodiments of the present disclosure, the tester may be further configured to acquire first charging request information of the device to be charged in a case that the device to be charged is connected to the charging conversion apparatus, and second charging request information transmitted by the device to be charged and received by the charging control unit; and determine that the charging control unit passes charging request response testing in a case that the first charging request information is the same as the second charging request information.

In this embodiment of the present disclosure, the tester may be further configured to acquire first charging capacity parameter transmitted by the energy management system and received by the charging control unit, where the first charging capacity parameter is calculated by the energy management system based on a charging capacity parameter of the energy storage apparatus and a charging capacity parameter of the AC-DC converter that are received; and determine that charging capacity parameter match testing passes in a case that the first charging capacity parameter is the same as the second charging capacity parameter, where the second charging parameter represents a charging capacity parameter calculated based on a measured charging capacity parameter of the energy storage apparatus and a measured charging capacity parameter of the AC-DC converter.

In some embodiments of the present disclosure, the tester may be further configured to acquire output parameter of the charging conversion apparatus transmitted by the charging control unit in a case that the device to be charged is charged through the charging conversion apparatus; and determine that the charging conversion apparatus passes output parameter testing in a case that the output parameter is less than or equal to a target parameter, where the target parameter is the minimum value in the first charging request information and the first charging capacity parameter.

In some embodiments of the present disclosure, the tester may be further configured to acquire first discharging parameter of the AC-DC converter in a case that the device to be charged is charged through the AC-DC converter; acquire second discharging parameter of the energy storage apparatus in a case that the device to be charged is charged through the energy storage apparatus; acquire third discharging parameter of the AC-DC converter and fourth discharging parameter of the energy storage apparatus in a case that the device to be charged is charged through the AC-DC converter and the energy storage apparatus; and determine that the AC-DC converter and the energy storage apparatus pass discharging parameter testing in a case that the first discharging parameter and the third discharging parameter are less than or equal to the charging capacity parameter of the AC-DC converter and the second discharging parameter and the fourth discharging parameter are less than or equal to the charging capacity parameter of the energy storage apparatus.

In some embodiments of the present disclosure, the charging conversion apparatus may include at least two DC-DC converters connected in parallel; the tester may be further configured to acquire respective output data of the at least two DC-DC converters in a case that power is supplied to the device to be charged through the charging conversion apparatus; determine output difference information based on the output data, where the output difference information represents difference information between currents respectively outputted by the at least two DC-DC converters; and determine that the charging conversion apparatus passes circulating current testing in a case that the output difference information is less than or equal to a second threshold.

In some embodiments of the present disclosure, the tester may be further configured to write first software version information to the battery management unit, so that the battery management unit transmits the first software version information to the energy management system; receive second software version information transmitted by the energy management system; and determine that the energy management system passes software version reading testing in a case that the first software version information is the same as the second software version information.

In some embodiments of the present disclosure, the tester may be further configured to transmit a high-voltage applying instruction to the energy management system; determine that the energy storage apparatus passes high-voltage applying testing in a case that the energy management system controls the battery management unit to complete a high-voltage applying operation on the energy storage apparatus in response to the high-voltage applying instruction; transmit a high-voltage removal instruction to the energy management system; and determine that the energy storage apparatus passes high-voltage removal testing in a case that the energy management system controls the battery management unit to complete a high-voltage removal operation on the energy storage apparatus in response to the high-voltage removal instruction.

In some embodiments of the present disclosure, the tester may be further configured to acquire state detection information of the battery management unit from the energy management system in a case that the energy storage apparatus is turned off; and determine that the battery management unit passes offline function testing in a case that the state detection information is that the battery management unit is in an offline state.

An embodiment of the present disclosure provides a testing system. The testing system includes a tester and a storage and charging system. The tester may be configured to acquire first charging data about that the energy management system controls an AC-DC converter to charge the energy storage apparatus in a case that the remaining power of the energy storage apparatus is less than or equal to a first threshold, and determine whether an energy storage function of the storage and charging system is normal based on the first charging data; the tester may be further configured to acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data. Accordingly, it can be seen that, when the energy storage function of the storage and charging system is normal, the energy management system may instruct the AC-DC converter to charge the energy storage apparatus in a case that the remaining power of the energy storage apparatus is less than or equal to the first threshold. Therefore, when the tester tests the energy storage function, it may acquire first charging data about that the energy management system instructs the AC-DC converter to charge the energy storage apparatus in a case that the remaining power of the energy storage apparatus is less than or equal to the first threshold, to determine whether the energy storage function of the storage and charging system is normal based on the first charging data, that is, determine whether the storage and charging system can automatically charge the energy storage apparatus in a case that the remaining power of the energy storage apparatus is less than or equal to the first threshold. For the charging function of the storage and charging system, under normal circumstances, three charging methods may be supported, including charging the device to be charged by using the AC-DC converter only, charging the device to be charged by using the energy storage apparatus only, and charging the device to be charged by using the AC-DC converter and the energy storage apparatus at the same time. Therefore, when the tester tests the charging function of the storage and charging system, it may acquire second charging data about that the energy management system controls the AC-DC converter and/or the energy storage apparatus to charge the device to be charged in a case that the device to be charged is connected, to determine whether the storage and charging system can normally execute the three charging methods based on the second charging data, thus achieving the effective testing of the automatic energy storage function and charging function of the storage and charging system. In addition, before the energy storage function and the charging function are tested, the communication function between the battery management unit and the energy management system may also be tested based on message data received by the energy management system and message data transmitted by the battery management unit, to ensure that the communication function between the battery management unit and the energy management system is normal. Based on the above testing, the use reliability of the storage and charging system can be effectively improved.

Based on the above embodiment, in another embodiment of the present disclosure, exemplarily, referring to FIG. 4, the storage and charging system in the testing system may include an energy management system 21, an energy storage apparatus 22, a charging conversion apparatus 23, and an AC-DC converter 24. The AC-DC converter 24 may be a bidirectional AC/DC converter. The charging conversion apparatus 23 may be a bidirectional DC/DC converter. The energy storage apparatus 22 may be controlled by a BMS. The charging conversion apparatus 23 may be controlled by a CCU. The storage and charging system may further include a wireless communication apparatus 25 configured for communication between various apparatuses or sub-modules in the storage and charging system. The storage and charging system may further include a charging gun 26. The testing system may further include a DC bus 31. The energy storage apparatus 22 and the charging conversion apparatus 23 may be connected to the DC bus 31. The charging gun 26 may be connected with the charging conversion apparatus 23. The testing system may further include a transformer 32. The AC-DC converter 24 is connected with the power grid 33 through the transformer 32 to obtain the electrical energy outputted by the power grid 33. The storage and charging system may charge a device to be charged connected to the charging gun, such as an electric vehicle 34.

In this embodiment of the present disclosure, when testing the storage and charging system, the tester may fully test the function, state, and communication of each module, then verify the coordination and cooperation between the modules, and finally perform the testing of the entire storage and charging system.

In some embodiments of the present disclosure, the energy storage apparatus in the storage and charging system is equipped with a high-power battery, which can achieve low-power input, such as extracting electricity from the power grid according to a power of 40kW to 50kW, and high-power output, such as charging the electric vehicle according to a power of 480kW or even more than 480kW. Therefore, it is necessary to focus on testing the communication, function, protection, and power performance of the battery.

Exemplarily, the testing items of the storage and charging system may include hardware testing items, software testing items, and overall testing items. The hardware testing items may include visual inspection, basic function testing, protocol consistency and interoperability testing, safety testing, protection function testing, accuracy performance testing, environmental adaptability testing, and electromagnetic compatibility testing. The software testing items may include interactive screen function testing, control module communication testing, micro-electro-mechanical system protection function testing, charging station body debugging software function testing, basic peripheral function testing, entire charging station function testing, cloud platform function testing, software function testing, and fault code testing.

Exemplarily, the visual inspection may inspect the appearance, labeling, nameplate, and product specification of each apparatus. The basic function testing may include testing of the communication function between sub-modules in the storage and charging system, testing of the basic charging functions, including insulation detection function, vehicle plug locking function, and charging control function, testing of the interaction function of the storage and charging system, and testing of the charging metering function. The protocol consistency and interoperability testing may include charging coordination control testing, communication state testing, charging voltage range testing, protective grounding verification testing, protection function testing of the energy storage apparatus, voltage testing of the energy storage apparatus, protection function testing of the energy storage apparatus, and output parameter match testing. The charging coordination control testing may include confirmation of the charging state, connection timing, connection, etc. The communication state testing may include testing of communication success, communication failure, communication interruption, etc. The protective grounding verification testing may include protective grounding verification of the energy storage apparatus. The output parameter match testing may include charging request response testing of the charging control unit, charging capacity parameter match testing, and output parameter testing of the charging conversion apparatus. The safety testing may include insulation withstand voltage testing, dielectric strength testing, impulse withstand voltage testing, and grounding resistance compliance testing. The protection function testing may include recharging protection measure testing of the storage and charging system, discharging protection measure testing of the storage and charging system, door opening protection testing, emergency stop function testing, and battery polarity testing. The accuracy performance testing may include output parameter accuracy testing, start and stop control accuracy testing, start output instantaneous peak voltage and current testing, standby power consumption testing, and circulating current testing. The output parameter accuracy testing may include setting and error measurement of output current or voltage. The start and stop control accuracy testing may include current adjustment time testing when a start command is given, and output current stop time when stopping. Environmental adaptability testing may include high temperature testing, low temperature testing, alternating humidity and heat testing, limit temperature rise testing, shell protection level testing, noise detection, anti-salt fog testing, and high temperature and high humidity operation testing. The high temperature testing may include testing of start and stop control and operation in various operating modes, such as testing of operation at temperature of 45°C. The low temperature testing may include testing of start and stop control and operation in various operating modes, such as testing of operation at temperature of-20°C. The shell protection level testing may include rain testing, etc. The electromagnetic compatibility testing may include radiated emission testing, conducted emission testing, electrostatic discharge testing, radio frequency electromagnetic field radiation immunity testing, electrical fast transient pulse group immunity testing, surge immunity testing, conducted disturbance immunity testing, and voltage sag, short-term interruption and voltage change immunity testing.

Exemplarily, the interactive screen function testing may include basic function testing, basic information testing, and other function testing. The basic function testing may include testing of display, operation, and content integrity. The basic information testing may include testing of basic information during charging, historical orders, device information, fault information, rate information, interactive QR codes, etc. The other function testing may include testing of display screen network configuration and vehicle identification code configuration function. The control module communication testing may include testing of communication between the sub-modules and control modules of the storage and charging system, and control module information accuracy testing. The control modules may include EMS, BMS, and CCU. The micro-electro-mechanical system protection function testing may include over-voltage protection testing, under-voltage protection testing, AC/DC converter fault protection testing, SOC lower limit protection testing, water immersion protection testing, over-current protection testing, over-temperature protection testing, access control protection testing, emergency stop function testing, relay adhesion diagnosis and control testing, and fault protection testing of the energy storage apparatus. The charging station body debugging software function testing may include debugging software and charging station body connection function testing, software version reading testing, automatic mode and manual mode switching testing, main contact control and feedback testing, auxiliary power relay control testing, power control output testing, automatic charging testing, charging completion testing, meter data reading function testing, high-precision module data reading testing connector state and connector return state testing, connector electronic lock locking/unlocking and feedback testing, connector temperature reading testing, connector connection voltage reading testing, charging station body configuration parameter read-write testing, charging module setting and output information testing, insulation function start and control testing, insulation testing information reading testing, liquid cooling module target temperature setting testing, liquid cooling module mode setting testing, liquid cooling connector enable testing, liquid cooling connector disable testing, liquid cooled battery core module fault injection testing, liquid cooling connector module data fault injection testing, fire protection module data information testing, fire protection module fault injection testing, charging station body fault information monitoring testing, control module over-the-air downloading technical function testing, software version reading inspection, high-voltage applying testing, high-voltage removal testing, and offline function testing. The basic peripheral function testing may include testing of communication with the battery, connector connection signal change testing in real vehicle testing, electronic lock locking/unlocking testing in real vehicle testing, on/off testing of the AC/DC converter, real-time data acquisition testing of the AC/DC converter, fault reporting testing of the AC/DC converter, data acquisition testing of the battery, and fault reporting testing of the battery. The entire charging station function testing may include real vehicle charging function testing, current limiting function testing, pulse current time testing, mini-program charging start testing, mini-program charging stop testing, mini-program charging information verification, emergency charging stop function testing during charging, and access-triggered charging stop function testing during charging. The cloud platform function testing may include charging station login authentication testing, login authentication response testing, charging station heartbeat packet testing, billing model verification request testing, billing model verification request response testing, offline monitoring data testing, BMS requirement and output testing during in the charging process, remote start command response testing, remote control start testing of the operation platform, remote shutdown command response testing, remote shutdown testing of the operation platform, transaction record testing, transaction record confirmation testing, timing setting response testing, timing setting testing, billing model response testing, billing model setting testing, and remote program upgrade testing. The software function testing may include code scanning and charging testing, required current and actual current consistency testing, required voltage and actual voltage consistency testing, order amount and duration rule testing, testing of consistency between software display device state and actual measurement of the charging station, account recharge use testing, SOC display and actual measurement data match testing, remote software stop testing, and charging record display consistency testing.

Exemplarily, the overall testing may include energy storage function testing, charging function testing, and aging testing. The aging testing may include multiple sets of operation experiments of the storage and charging system at different SOCs to verify whether the storage and charging system can automatically adjust the charging control strategy based on the requested power information in the charging request of the vehicle at different battery SOCs. It is also possible to conduct experiments by running the storage and charging system for a long period of time, such as running continuously for three to seven days, to verify whether the storage and charging system can still automatically adjust the charging control strategy.

What are described above are merely preferred embodiments of the present disclosure, and are not intended to limit the scope of protection of the present disclosure.

## Claims

1. A testing method for a storage and charging system, applied to a tester, the storage and charging system comprising an energy management system, an energy storage apparatus, and a charging conversion apparatus; the energy storage apparatus comprising a battery management unit; the method comprising:
acquiring first charging data about that the energy management system instructs an AC-DC converter to charge the energy storage apparatus in a case that the remaining power of the energy storage apparatus is less than or equal to a first threshold, and determining whether an energy storage function of the storage and charging system is normal based on the first charging data; and
acquiring second charging data about that the energy management system controls the AC-DC converter and/or the energy storage apparatus to charge a device to be charged in a case that the device to be charged is connected to the charging conversion apparatus, and determining whether a charging function of the storage and charging system is normal based on the second charging data, wherein the charging conversion apparatus is respectively connected with the AC-DC converter and the energy storage apparatus; the energy storage function and the charging function are tested in a case that a communication function between the battery management unit and the energy management system passes testing; and the testing of the communication function is completed based on message data received by the energy management system and message data transmitted by the battery management unit.

2. The testing method for a storage and charging system according to claim 1, wherein the second charging data comprises third charging information, fourth charging information, and fifth charging information; the method further comprises:
transmitting first charging instruction information to the energy management system, so that the energy management system controls the AC-DC converter to charge the device to be charged in response to the first charging instruction information, and acquires the third charging information, wherein the first charging instruction information is configured to instruct to charge the device to be charged through the AC-DC converter;
transmitting second charging instruction information to the energy management system, so that the energy management system controls the energy storage apparatus through the battery management unit to charge the device to be charged in response to the second charging instruction information, and acquires the fourth charging information, wherein the second charging instruction information is configured to instruct to charge the device to be charged through the energy storage apparatus; and
transmitting third charging instruction information to the energy management system, so that the energy management system controls the AC-DC converter and the battery management unit in response to the first charging instruction information to charge the device to be charged through the AC-DC converter and the energy storage apparatus, and acquires the fifth charging information.

3. The testing method for a storage and charging system according to claim 1 or 2, wherein the method further comprises:
acquiring first message data of the energy management system and second message data of the battery management unit before the energy storage function and the charging function are tested, wherein the second message data represents message data generated by the battery management unit and transmitted to the energy management system, and the first message data represents message data received by the energy management system from the battery management unit;
comparing the first message data and the second message data to obtain a comparison result; and
determining that the communication function between the battery management unit and the energy management system passes testing in a case that the comparison result is that the first message data is the same as the second message data.

4. The testing method for a storage and charging system according to claim 3, wherein after the determining that the communication function between the battery management unit and the energy management system passes testing in a case that the comparison result is that the first message data is the same as the second message data, the method further comprises:
acquiring a protection instruction generated by the energy management system in response to a fault message transmitted by the battery management unit;
acquiring the fault message of the battery management unit and determining a fault level of the fault message; and
determining that a protection function of the energy storage apparatus passes testing in a case that the protection instruction is a protection instruction corresponding to the fault level.

5. The testing method for a storage and charging system according to claim 3 or 4, wherein after the determining that the communication function between the battery management unit and the energy management system passes testing in a case that the comparison result is that the first message data is the same as the second message data, the method further comprises:
acquiring first voltage data of the energy storage apparatus at different levels of remaining power and second voltage data of a battery in the energy storage apparatus; and
determining that the voltage of the energy storage apparatus passes testing in a case that the first voltage data conforms to a first voltage range and the second voltage data conforms to a second voltage range.

6. The testing method for a storage and charging system according to any one of claims 1 to 5, wherein the charging conversion apparatus comprises a charging control unit; the method further comprises:
acquiring first charging request information of the device to be charged in a case that the device to be charged is connected to the charging conversion apparatus, and second charging request information transmitted by the device to be charged and received by the charging control unit; and
determining that the charging control unit passes charging request response testing in a case that the first charging request information is the same as the second charging request information.

7. The testing method for a storage and charging system according to claim 6, wherein after the determining that the charging control unit passes charging request response testing in a case that the first charging request information is the same as the second charging request information, the method further comprises:
acquiring a first charging capacity parameter transmitted by the energy management system and received by the charging control unit, wherein the first charging capacity parameter is calculated by the energy management system based on a charging capacity parameter of the energy storage apparatus and a charging capacity parameter of the AC-DC converter that are received; and
determining that charging capacity parameter match testing passes in a case that the first charging capacity parameter is the same as the second charging capacity parameter, wherein the second charging parameter represents a charging capacity parameter calculated based on a measured charging capacity parameter of the energy storage apparatus and a measured charging capacity parameter of the AC-DC converter.

8. The testing method for a storage and charging system according to claim 7, wherein after the determining that charging capacity parameter match testing passes in a case that the first charging capacity parameter is the same as the second charging capacity parameter, the method further comprises:
acquiring an output parameter of the charging conversion apparatus transmitted by the charging control unit in a case that the device to be charged is charged through the charging conversion apparatus; and
determining that the charging conversion apparatus passes output parameter testing in a case that the output parameter is less than or equal to a target parameter, wherein the target parameter is the minimum value in the first charging request information and the first charging capacity parameter.

9. The testing method for a storage and charging system according to claim 8, wherein after the determining that the charging conversion apparatus passes output parameter testing in a case that the output parameter is less than or equal to a target parameter, the method further comprises:
acquiring a first discharging parameter of the AC-DC converter in a case that the device to be charged is charged through the AC-DC converter;
acquiring a second discharging parameter of the energy storage apparatus in a case that the device to be charged is charged through the energy storage apparatus;
acquiring a third discharging parameter of the AC-DC converter and a fourth discharging parameter of the energy storage apparatus in a case that the device to be charged is charged through the AC-DC converter and the energy storage apparatus; and
determining that the AC-DC converter and the energy storage apparatus pass discharging parameter testing in a case that the first discharging parameter and the third discharging parameter are less than or equal to the charging capacity parameter of the AC-DC converter and the second discharging parameter and the fourth discharging parameter are less than or equal to the charging capacity parameter of the energy storage apparatus.

10. The testing method for a storage and charging system according to any one of claims 1 to 9, wherein the charging conversion apparatus comprises at least two DC-DC converters connected in parallel; the method further comprises:
acquiring respective output data of the at least two DC-DC converters in a case that power is supplied to the device to be charged through the charging conversion apparatus;
determining output difference information based on the output data, wherein the output difference information represents difference information between currents respectively outputted by the at least two DC-DC converters; and
determining that the charging conversion apparatus passes circulating current testing in a case that the output difference information is less than or equal to a second threshold.

11. The testing method according to any one of claims 1 to 10, wherein the method further comprises:
writing first software version information to the battery management unit, so that the battery management unit transmits the first software version information to the energy management system;
receiving second software version information transmitted by the energy management system; and
determining that the energy management system passes software version reading testing in a case that the first software version information is the same as the second software version information.

12. The testing method according to any one of claims 1 to 11, wherein the method further comprises:
transmitting a high-voltage applying instruction to the energy management system;
determining that the energy storage apparatus passes high-voltage applying testing in a case that the energy management system controls the battery management unit to complete a high-voltage applying operation on the energy storage apparatus in response to the high-voltage applying instruction;
transmitting a high-voltage removal instruction to the energy management system; and
determining that the energy storage apparatus passes high-voltage removal testing in a case that the energy management system controls the battery management unit to complete a high-voltage removal operation on the energy storage apparatus in response to the high-voltage removal instruction.

13. The testing method according to any one of claims 1 to 12, wherein the method further comprises:
acquiring state detection information of the battery management unit from the energy management system in a case that the energy storage apparatus is turned off; and
determining that the battery management unit passes offline function testing in a case that the state detection information is that the battery management unit is in an offline state.

14. A testing system, comprising a tester and a storage and charging system connected with the tester, wherein the storage and charging system comprises an energy management system, an energy storage apparatus, and a charging conversion apparatus; the energy storage apparatus comprises a battery management unit; the charging conversion apparatus is respectively connected with an AC-DC converter and the energy storage apparatus;
the tester is configured to acquire first charging data about that the energy management system controls the AC-DC converter to charge the energy storage apparatus in a case that the remaining power of the energy storage apparatus is less than or equal to a first threshold, and determine whether an energy storage function of the storage and charging system is normal based on the first charging data;
the tester is further configured to acquire second charging data about that the energy management system controls the AC-DC converter and/or the energy storage apparatus to charge a device to be charged in a case that the device to be charged is connected to the charging conversion apparatus, and determine whether a charging function of the storage and charging system is normal based on the second charging data, wherein the energy storage function and the charging function are tested in a case that a communication function between the battery management unit and the energy management system passes testing; and the testing of the communication function is completed based on message data received by the energy management system and message data transmitted by the battery management unit.

15. The testing system according to claim 14, wherein the energy storage apparatus comprises a battery management unit; the charging conversion apparatus comprises a charging control unit;
the battery management unit is configured to control the energy storage apparatus to charge the device to be charged;
the charging control unit is configured to control the charging conversion apparatus to output charging current to the device to be charged.

16. The testing system according to claim 14 or 15, wherein
the storage and charging system further comprises a charging gun; the charging gun is connected with the charging conversion apparatus;
the AC-DC converter, the energy storage apparatus, and the charging conversion apparatus are connected to a DC bus.
